(19) Europäisches Patentamt
European Patent Office
Office européen des brevets

(11) **EP 1 833 260 A2**

(12) **EUROPÄISCHE PATENTANMELDUNG**

(43) Veröffentlichungstag:
**12.09.2007 Patentblatt 2007/37**

(51) Int Cl.:
***H04N 7/32*** *(2006.01)*

(21) Anmeldenummer: **07004778.2**

(22) Anmeldetag: **08.03.2007**

(84) Benannte Vertragsstaaten:
**AT BE BG CH CY CZ DE DK EE ES FI FR GB GR HU IE IS IT LI LT LU LV MC MT NL PL PT RO SE SI SK TR**
Benannte Erstreckungsstaaten:
**AL BA HR MK YU**

(30) Priorität: **09.03.2006 DE 102006011022**

(71) Anmelder: **Netviewer GmbH**
**76133 Karlsruhe (DE)**

(72) Erfinder: **Neumann, Jürgen**
**76149 Karlsruhe (DE)**

(74) Vertreter: **Rummler, Felix et al**
**R.G.C. Jenkins & Co**
**Martiusstraße 5/III. OG**
**80802 München (DE)**

(54) **Zweidimensionales Adaptives Bildkompressionsverfahren**

(57) Erfindungsgemäß ist ein Verfahren zur Kompression von Daten geschaffen, die eine Vielzahl von Informationseinheiten enthalten, umfassend: Bestimmen von einen oder mehreren Erwartungswerten für jede der Informationseinheiten; für jede Informationseinheit Bestimmen einer Übereinstimmung des Wertes der Informationseinheit mit dem einen oder den mehreren Erwartungswerten; und Erzeugen von Ausgangsdaten, die Informationen über Übereinstimmungen der Werte der Informationseinheiten mit dem einen oder den mehreren Erwartungswerten enthalten, sowie Informationen über die Werte der Informationseinheiten, falls Nichtübereinstimmungen mit dem einen oder den mehreren Erwartungswerten festgestellt werden, wobei die Erwartungswerte auf Grundlage von Werten von Informationseinheiten gebildet werden, die bereits den vorangegangenen Schritten zur Kompression unterzogen worden sind und in Bezug auf die vorliegende Informationseinheit einen zweidimensionalen Kontext bilden. Die Informationseinheiten werden insbesondere durch Pixel eines zweidimensionalen Bildes gebildet, wobei der zweidimensionale Kontext durch Pixel in beiden Bilddimensionen (x, y) gebildet wird.

Fig. 2

EP 1 833 260 A2

**Beschreibung**

Die vorliegende Erfindung betrifft ein Verfahren zur Kompression von Daten, und insbesondere ein zweidimensionales adaptives Bildkompressionsverfahren.

**Hintergrund der Erfindung**

Bekannte verlustfreie Bildkompressionsverfahren (z.B. GIF; PNG) beruhen auf zwei Kompressionsprinzipien:

- Entropiecodierung: (z.B. Huffman-Codierung, arithmetische Codierung)
- Stringersatzverfahren: (z.B. Run-Length-Codierung, LZ77, LZ78).

Es ist auch bekannt, diese beiden Kompressionsprinzipien miteinander zu kombinieren.

Bei bekannten Stringersatzverfahren wird das (ursprünglich zweidimensionale) Bild als eindimensionale Pixelkette kodiert, die wiederum Pixel für Pixel kodiert wird. Der lokale Kontext, der für die Kompression eines Pixels genutzt werden kann, besteht hierdurch lediglich aus den unmittelbar links vom gerade bearbeiteten Pixel liegenden Pixeln.

Bei der bekannten Lauflängenkodierung werden nur horizontale "Läufe" von gleichfarbigen Pixeln erkannt. Dadurch wird ein Bild, das aus horizontalen Streifen besteht, wesentlich besser komprimiert als ein Bild, das aus vertikalen Streifen besteht.

Die gleichen Einschränkungen gelten für alle "eindimensionalen" Stringersatzverfahren.

Generelles Anliegen bei der verlustfreien Kompression von Daten, insbesondere Bilddaten, ist es, eine möglichst hohe Kompressionsrate zu erreichen, d.h. ein zu komprimierendes Bild soll durch möglichst wenig Daten beschrieben werden.

Vor diesem Hintergrund ist es eine Aufgabe der Erfindung, die Kompressionsrate gegenüber bekannten Verfahren zu steigern, ohne bei der Kompression/ Dekompression einen wesentlich größeren Rechenaufwand zu benötigen.

**Zusammenfassung der Erfindung**

Diese Aufgabe wird durch die in den Hauptansprüchen angegebene Erfindung gelöst. Vorteilhafte Ausgestaltungen sind in den Unteransprüchen angegeben.

Insbesondere basiert die Erfindung auf der Erkenntnis, dass mittels Verwendung von Erwartungswerten, die anhand eines zweidimensionalen "Kompressionskontextes" gebildet werden, die Kompressionsrate gegenüber bekannten "eindimensionalen" Verfahren erhöht werden kann.

**Beschreibung von Ausführungsbeispielen**

Die vorliegende Erfindung wird nun anhand von Ausführungsbeispielen mit Bezugnahme auf die Zeichnungen erläutert. Es zeigen:

Figur 1 schematisch ein zweidimensionales Pixelraster, auf welches des erfindungsgemäße Verfahren anwendbar ist;

Figur 2 ein Flussdiagramm, das die einzelnen Schritte eines Kompressionsverfahrens gemäß einer Ausgestaltung der Erfindung illustriert; und

Figur 3 ein Flussdiagramm, das die einzelnen Schritte eines Dekompressionsverfahrens nach einer Ausgestaltung der Erfindung illustriert.

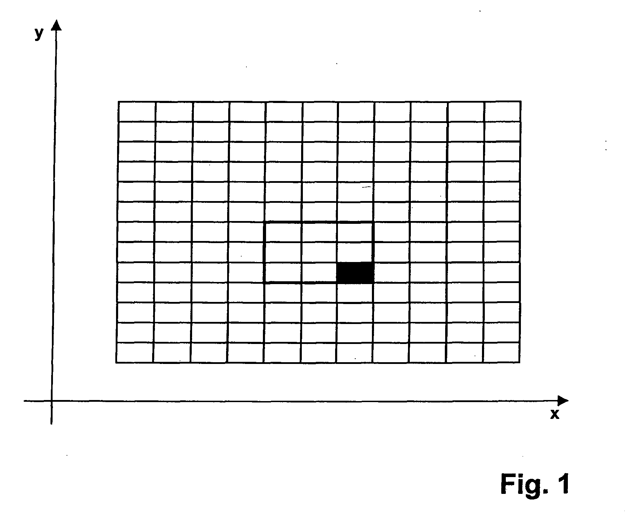

Figur 1 zeigt ein zweidimensionales Pixelraster, auf welches das Kompressionsverfahren gemäß der vorliegenden Erfindung anwendbar ist. Gemäß dem Kompressionsverfahren wird für jedes Pixel ein "Kontextwert" gebildet, der auf den Werten eines vorbestimmten Parameters (z.B. Farbe, Helligkeit etc) bestimmter in zwei Dimensionen vorangehender Pixel basiert. In Figur 1 ist eines der Pixel schwarz angezeigt. Zur Bestimmung des Kontextwertes dieses Pixels werden die Werte von entgegen der x- oder y-Richtung nicht weiter als zwei Pixel entfernten Pixel verwendet, d.h. die Werte aller Pixel innerhalb der angezeigten Markierung.

Die Reichweite des berücksichtigen Kontexts, d.h. die Anzahl der zu berücksichtigenden Pixel entgegen der x- und y-Richtung kann je nach Anwendung unterschiedlich bestimmt werden. Auch kann die daraus reslutierende "Kontextform" variieren - diese kann beispielsweise kreisförmig sein.

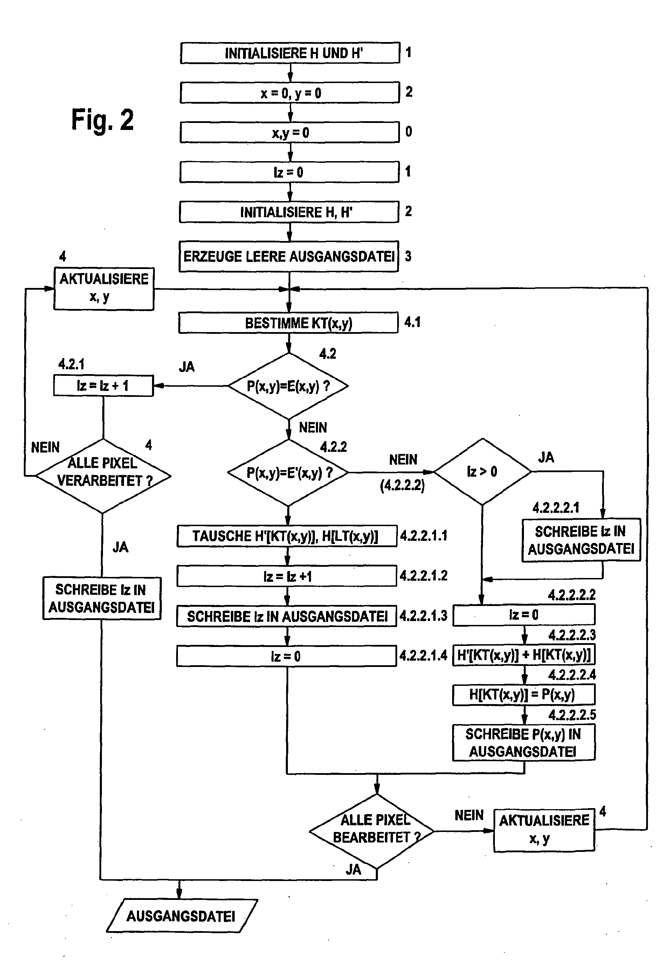

Die Kontextwerte werden zur Bestimmung von Erwartungswerten verwendet, wie nachfolgend in Bezug auf Figur 2 beschrieben.

Bezugnehmend auf Figur 2 werden nun die Schritte eines Kompressionsverfahrens gemäß einer Ausgestaltung der Erfindung beschrieben:

0. Setzen der Pixelkoordinaten x und y auf 0.

1. Initialisieren eines Lauflängenzählers *lz,* d.h. Setzen von *lz* auf 0.

2. Initialisieren von ersten und zweiten Hashtabellen *H* und *H* (mit jeweils *maxhash* Einträgen, siehe unten) und Setzen aller Einträge beider Hashtabellen auf den Farbwert 0.

3. Erzeugen einer leere Ausgangsdatei.

4. Für den Farbwert jedes Pixels *P(x,y)* des zu komprimierenden Bildes, Durchführen der folgenden Schritte:

4.1 Berechne eines Kompressionskontextes *KT(x,y)*

Der Kompressionskontext ergibt sich dabei aus einer zweidimensionalen Umgebung des Pixels:

$$KT(x,y) := f(P(x-2,y-2), P(x-1,y-2), P(x,y-2),$$

$$P(x-2,y-1), P(x-1,y-1), P(x,y-1),$$

$$P(x-2,y), P(x-1,y))$$

Die Funktion *f* hat die Eigenschaften einer Prüfsummenfunktion mit Werten zwischen *0* und *maxhash-1.*

Dazu wird definiert: bei x<0 oder y<0 gilt: P(x,y)=0.

Dies betrifft die Berechnung des Kompressionskontexts von Pixeln am linken und am oberen Bildrand. Das Bild wird demnach nach links und nach oben um zwei Reihen und zwei Spalten "gedachte" schwarze Pixel erweitert.

Das erfindungsgemäße Verfahren ist jedoch nicht auf einen Kompressionskontext der Reichweite 2/2 beschränkt; vielmehr können auch andere Reichweiten verwendet werden. Alle im Kontext enthaltenen Pixel sind vor dem aktuellen Pixel übertragen (d.h. der Komprimierung unterzogen) worden.

Werden die Pixel in einer anderen Reihenfolge bearbeitet, als hier beschrieben (von links nach rechts und von oben nach unten), so wird der Kompressionskontext entsprechend angepasst.

4.2 Vergleichen des tatsächlichen Farbwerts *P(x,y)* des Pixels mit einem Erwartungswert *E(x,y)* für den Farbwert, wobei sich der Erwartungswert ergibt als:

$$E(x,y) := H[KT(x,y)]$$

4.2.1 Falls der tatsächliche Farbwert dem Erwartungswert entspricht: Erhöhen des Lauflängenzählers *lz* um 1.

4.2.2 Ansonsten: Vergleichen des tatsächlichen Farbwerts P(x,y) mit dem zweiten Erwartungswert E'(x,y), wobei sich der zweite Erwartungswert ergibt als:

$$E'(x,y) := H'[KT(x,y)]$$

4.2.2.1 Falls der tatsächliche Farbwert dem zweiten Erwartungswert entspricht: Durchführen folgender Schritte:

4.2.2.1.1 Gegenseitiges Tauschen der Werte *H'[KT(x,y)]* und *H[KT(x,y)]*.

4.2.2.1.2 Erhöhen des Lauflängenwerts *lz* um 1.

4.2.2.1.3 Schreiben des Lauflängenwerts *lz* in die Ausgangsdatei.

4.2.2.1.4 Rücksetzen des Lauflängenwerts *lz* auf 0.

4.2.2.2 Ansonsten: Durchführen folgender Schritte:

4.2.2.2.1 Bei *lz>0:* Schreiben des Lauflängenwerts *lz* in die Ausgangsdatei.

4.2.2.2.2 Rücksetzen des Lauflängenwerts *lz* auf 0.

4.2.2.2.3 Ersetzen des zweiten Erwartungswertes *H'[KT(x,y)]* durch den ersten Erwartungswert *H [KT(x,y)]*

$$H'[KT(x,y)] := H[KT(x,y)]$$

4.2.2.2.4 Speichern des tatsächlichen Farbwerts als neuen Erwartungswert:

$$H[KT(x,y)] := P(x,y)$$

4.2.2.2.5 Schreiben des Farbwerts *P(x,y)* in die Ausgangsdatei, versehen mit einer eindeutigen Marke *M* Die Marke M dient zur Unterscheidung von Lauflängen und Farbwerten in der Ausgangsdatei. Insbesondere folgt auf die Marke *M* immer genau ein Farbwert.

Die oben beschriebenen Schritte (ausgenommen die Initialisierung) werden für alle Pixel des zu komprimierenden Bildes wiederholt.

Sind alle Pixel verarbeitet worden und entsprach der Farbwert des letzten Pixels dem ersten Erwartungswert E(x,y), so wird abschließend der Lauflängenzählers *lz* um 1 erhöht und in die Ausgangsdatei übertragen.

Anstelle des Schrittes 4.2.2.2.5 kann auch ein Nachschlagen in einer Cashing-Tabelle der zuletzt geschriebenen Farben erfolgen, und (im Erfolgsfall) nur der entsprechende Cash-Index geschrieben werden. Die Farb-Cash-Tabelle wird dann entsprechend aktualisiert.

Die Ausgangsdatei kann anschließend noch mit einem Entropiekodierer (z.B. Huffman-Verfahren) "nachkomprimiert" werden.

Bei der Durchführung des Kompressionsverfahrens wird folgendes bewirkt: Für jedes Pixel, dessen Farbwert *P(x,y)* dem derzeitigen (ersten) Erwartungswert *E(x,y)* entspricht, wird die Lauflänge *lz* um eins erhöht. Entspricht der Farbwert *P(x,y)* nicht mehr dem ersten Erwartungswert *E(x,y),* dafür aber dem vorherigen (zweiten) Erwartungswert *E' (x,y),* so wird die Lauflänge *lz* um eins erhöht, in die Ausgangsdatei geschrieben und anschließend zurückgesetzt. Außerdem werden die Hashtabellen *H* und *H'* aktualisiert, d.h. der in der ersten Hashtabelle *H* enthaltene erste (nicht mehr zutreffende) Erwartungswert *E(x,y)* und der in der zweiten Hashtabelle *H'* enthaltene zweite (nun zutreffende) Erwartungswert *E'(x,y),* werden gegenseitig ausgetauscht.

Da die (derzeitigen und vorherigen) Erwartungswerte auf der Empfängerseite bekannt sind, müssen damit übereinstimmende Farbwerte nicht in die Ausgangsdatei geschrieben werden. Einen Übergang von einem Farbwert, der dem derzeitigen (ersten) Erwartungswert entspricht, zu einem Farbwert, der dem vorherigen (zweiten) Erwartungswert entspricht, wird auf Empfängerseite anhand von zwei aufeinanderfolgenden Lauflängenwerten in der Ausgangsdatei erkannt.

Lediglich ein neuer, "unerwarteter" Farbwert muss in die Ausgangsdatei geschrieben werden.

Dies kann anhand eines einfachen Beispiels veranschaulicht werden. In diesem Beispiel steht "A" für Pixel mit einem Farbwert, der dem derzeitigen Erwartungswert entspricht. "B" steht für Pixel mit einem Farbwert, der dem vorherigen Erwartungswert entspricht. "C" steht für einen Pixel mit einem neuen, unerwarteten Farbwert. Eine beispielhafte Pixelfolge lautet nun

AAAAABAAAAC

Für jedes Pixel A wird die Lauflänge um eins erhöht. Bei Erreichen des Pixels B beträgt die Lauflänge demnach 5. Die Lauflänge wird anschließend noch um eins auf 6 erhöht, in die Ausgangsdatei geschrieben und auf Null zurückgesetzt. Anschließend wird die Lauflänge wiederum für jedes Pixel A um eins erhöht. Bei Erreichen des Pixels C beträgt die Lauflänge 4 und wird in die Ausgangsdatei geschrieben. Da das Pixel C einen unerwarteten Farbwert aufweist, wird dieser ebenfalls in die Ausgangsdatei geschrieben (versehen mit der Marke *M).* Der Inhalt der Ausgangsdatei ist somit

64*MC*

Die oben beschriebenen Hashtabellen sind zu Beginn der Komprimierung auf der Sender- und der Empfängerseite identisch. Ausgehend davon werden die Hash-Tabellen sowohl auf der Senderseite als auch der Empfängerseite abhängig von der Abfolge der übertragenen bzw. empfangenen Pixelinformationen gemäß dem oben beschriebenen Algorithmus aktualisiert. Mittels der Hashtabellen kann auf der Empfängerseite dann die Pixelfolge anhand des Inhalts der Ausgangsdatei rekonstruiert werden.

Aus dem Inhalt der Ausgangsdatei kann somit bestimmt werden, dass auf 5 Pixel mit einem jeweils dem ersten Erwartungswert entsprechenden Farbwert (A) 1 Pixel mit einem dem zweiten Erwartungswert entsprechenden Farbwert (B) folgt, gefolgt von 4 Pixeln, die jeweils einen dem (neuen) ersten Erwartungswert entsprechenden Farbwert aufweisen, gefolgt von einem Pixel mit einem neuen Farbwert (C). Zu beachten ist, dass aufeinanderfolgende Pixel, deren Farbwert jeweils einem Erwartungswert entspricht, nicht zwangsläufig den *gleichen* Farbwert aufweisen - vielmehr hat jedes Pixel einen *erwarteten* Farbwert.

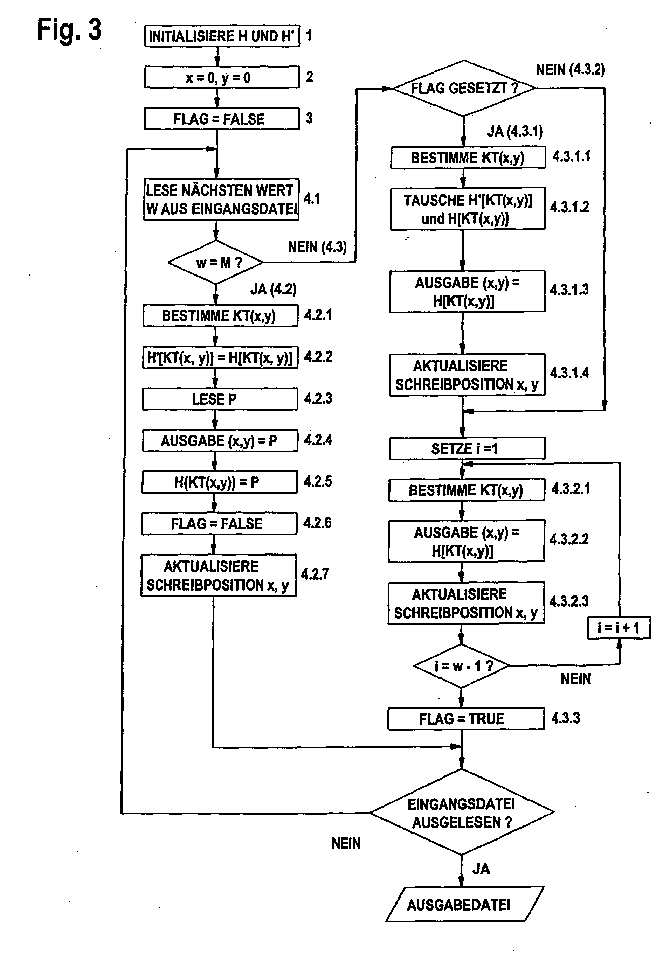

Nachfolgend werden unter Bezugnahme auf Figur 3 die Schritte eines Verfahrens zur Dekomprimierung einer gemäß dem oben beschriebenen Kompressionsverfahren erzeugten Ausgangsdatei (nachfolgend "Eingangsdatei") auf der Empfängerseite beschrieben:

1. Initialisieren von ersten und zweiten Hashtabellen *H* und *H'* (mit jeweils *maxhash* Einträgen, siehe oben) und Setzen aller Einträge beider Hashtabellen auf den Farbwert 0.

2. Setzen der aktuellen Schreibposition auf *(x=0; y=0).*

3. Setzen eines Flag:

*flag : = FALSE*

4. Öffnen der Eingangsdatei und Durchführen der folgenden Schritte, bis das Ende der Eingangsdatei erreicht ist:

4.1 Lesen eines Wert w aus der Eingangsdatei.

4.2 Falls w der Marke M entspricht: Durchführen der folgenden Schritte:

4.2.1 Berechnen des Kompressionskontext *KT (x,y)*

(Der Kompressionskontext wird auf der Empfängerseite mittels der bereits in eine Ausgabedatei *Ausgabe [x, y]* geschriebenen Pixelwerte berechnet, analog zur Berechnung des Kompressionskontextes auf der Empfängerseite, siehe oben).

4.2.2 Ersetzen des zweiten Erwartungswerts *H'[KT(x,y)]* durch den ersten Erwartungswert *H[KT(x,y)]:*

$$H'[KT(x,y)] := H[KT(x,y)]$$

4.2.3 Lesen des Farbwerts P aus der Eingangsdatei (folgt auf die Marke *M).*

4.2.4 Setzen des Pixels an der aktuellen Position (x,y) der Ausgabedatei auf den Wert P

*Ausgabe [x, y]: = P*

4.2.5 Übernehmen des tatsächlichen Farbwerts als neuen Erwartungswert:

$$H[KT(x,y)] := P$$

4.2.6 Rücksetzen des Flags:

*flag : = FALSE*

4.2.7 Aktualisiere die aktuelle Schreibposition (x,y):

*wenn x<Bildbreite dann x : = x+1 sonst (x:=0; y:=y+1)*

4.3 Ansonsten Durchführen der folgenden Schritte:

4.3.1 Wenn das Flag gesetzt ist: Durchführen der folgenden Schritte:

4.3.1.1 Berechnen des Kompressionskontextes *KT (x,y)*

4.3.1.2 Gegenseitiges Tauschen der Werte *H[KT(x,y)]* und *H[KT(x,y)]*

4.3.1.3 Setzen des Pixels an der aktuellen Position (x,y) in der Ausgabedatei auf den Erwartungswert *H[KT(x,y)]*

$$Ausgabe [x, y] := H [KT(x,y)]$$

4.3.1.4 Aktualisieren der aktuelle Schreibposition (x,y):

*wenn x<Bildbreite dann x : = x+1 sonst (x:=0; y:=y+1)*

4.3.2 Ansonsten Wiederholen der folgenden Schritte *w*-1 mal:

4.3.2.1 Berechnen des Kompressionskontextes *KT (x,y)*
4.3.2.2 Setzen des Pixel an der aktuellen Position (x,y) in der Ausgabedatei auf den Erwartungswert *H[KT(x,y)]*

$$Ausgabe\ [x,\ y]\ := H\ [KT(x,y)]$$

4.3.2.3 Aktualisieren der aktuellen Schreibposition (x,y):
*wenn x<Bildbreite dann x : = x+1 sonst (x:=0; y:y+1)*

4.3.3 Setze des Flags:
*flag : = TRUE*

Anzumerken ist, dass das Verfahren nicht auf eine bestimmte Darstellung des Farbwerts eines Pixels beschränkt ist. Beispielsweise können die Farbewerte als R,G,B-Triple oder (bei monochromen Bildern) als einzelner Helligkeitswert dargestellt sein.

**Patentansprüche**

1. Verfahren zur Kompression von Daten, die eine Vielzahl von Informationseinheiten enthalten, wobei das Verfahren für eine vorliegende der Vielzahl von Informationseinheiten folgende Schritte umfasst:

   (A) Vergleichen des Wertes eines vorbestimmten Parameters der vorliegenden Informationseinheit mit einem ersten Erwartungswert (4.2 in Fig. 2); und
   bei Übereinstimmung:

   (a) Erhöhen des Standes eines Zählers (4.2.1 in Fig. 2); oder bei Nichtübereinstimmung:
   (b) Vergleichen des Wertes des vorbestimmten Parameters der vorliegenden Informationseinheit mit einem zweiten Erwartungswert (4.2.2 in Fig. 2); und
   bei Übereinstimmung:

   (aa) Erhöhen des Zählerstandes (4.2.2.1.2 in Fig. 2); und
   (ab) Übertragen des Zählerstandes in eine Ausgangsdatei (4.2.2.1.3 in Fig. 2);

   oder bei Nichtübereinstimmung:

   (ba) Übertragen des Zählerstandes in die Ausgangsdatei, falls der Zählerstand größer Null ist (4.2.2.2.1 in Fig. 2); und
   (bb) Übertragen des Wertes des vorbestimmten Parameters der vorliegenden Informationseinheit in die Ausgangsdatei (4.2.2.2.5 in Fig. 2).

2. Verfahren nach Anspruch 1, wobei die ersten und zweiten Erwartungswerte auf Grundlage von Werten von Informationseinheiten gebildet werden, die bereits den vorangegangenen Schritten zur Kompression unterzogen worden sind.

3. Verfahren nach Anspruch 1 oder 2, wobei die ersten und zweiten Erwartungswerte auf Grundlage von Werten von Informationseinheiten gebildet werden, die in Bezug auf die vorliegende Informationseinheit einen zweidimensionalen Kontext bilden.

4. Verfahren nach einem der vorhergehenden Ansprüche, umfassend:

   Bilden eines Kontextwertes bezüglich der vorliegenden Informationseinheit durch Bestimmen des Wertes des vorbestimmten Parameters von Informationseinheiten, die bereits den vorangegangenen Schritten zur Kompression unterzogen worden sind (4.1 in Fig. 2);
   Führen von ersten und zweiten Hashtabellen, wobei jedem möglichen Kontextwert ein Eintrag in der ersten und in der zweiten Hashtabelle zugeordnet ist, und wobei die ersten und zweiten Erwartungswerte durch Einträge in der ersten bzw. zweiten Hashtabelle gebildet werden, die dem Kontextwert zugeordnet sind.

5. Verfahren nach Anspruch 4, wobei bei Übereinstimmung des Wertes des vorbestimmten Parameters der vorliegenden Informationseinheit mit einem zweiten Erwartungswert ein Anpassen der ersten und zweiten Erwartungswerte durch gegenseitiges Austauschen der entsprechenden Einträge in der ersten bzw. zweiten Hashtabelle durchgeführt wird (4.2.2.1.1 in Fig. 2).

6. Verfahren nach einem der vorhergehenden Ansprüche, wobei bei Übereinstimmung des Wertes des vorbestimmten Parameters der vorliegenden Informationseinheit mit dem zweiten Erwartungswert ein Rücksetzen des Zählerstandes durchgeführt wird (4.2.2.1.4 in Fig. 2).

7. Verfahren nach Anspruch 4, wobei bei Nichtübereinstimmung des Wertes des vorbestimmten Parameters der vorliegenden Informationseinheit mit dem zweiten Erwartungswert; ein Anpassen der ersten und zweiten Erwartungswerte durch folgende Schritte durchgeführt wird:

   Ersetzen des dem zweiten Erwartungswert entsprechenden Eintrages in der zweiten Hashtabelle durch den dem ersten Erwartungswert entsprechenden Eintrag in der ersten Hashtabelle (4.2.2.2.3 in Fig. 2); und Ersetzen des dem ersten Erwartungswert entsprechenden Eintrages in der ersten Hashtabelle durch den Wert des bestimmten Parameters der vorliegenden Informationseinheit (4.2.2.2.4 in Fig. 2).

8. Verfahren nach den Ansprüchen 1 bis 7, umfassend:

   Wiederholen der Schritte für alle Informationseinheiten, wobei, wenn für die letzte der Informationseinheiten Schritt (a) durchgeführt wurde, eine Übertragung des Zählerstandes in die Ausgangsdatei erfolgt.

9. Verfahren nach Anspruch 8,
   wobei zu Beginn der Durchführung des Verfahrens für alle Informationseinheiten die ersten und zweiten Hashtabellen initialisiert werden, (2 in Fig. 2), und
   wobei der Zählerstand auf Null gesetzt wird (1 in Fig. 2).

10. Verfahren zur Dekompression von Daten in einer Eingangsdatei, die nach dem Verfahren nach einem der vorhergehenden Ansprüche komprimiert worden sind, umfassend:

    Auslesen eines Wertes aus der Eingangsdatei (4.1 in Fig. 3); und
    falls es sich bei dem ausgelesenen Wert um einen Wert des vorbestimmten Parameters handelt, Zuordnen des Wertes zu einer aktuellen, zur Ausgabe bestimmten Informationseinheit (4.2.4 in Fig. 3).

11. Verfahren nach Anspruch 10, umfassend:

    Bilden eines Kontextwertes bzgl. der aktuellen Informationseinheit auf Grundlage von Werten, die bereits vorangegangenen zur Ausgabe bestimmten Informationseinheiten zugeordnet worden sind (4.2.1, 4.3.1.1, 4.3.2.1 in Fig. 3); und
    Führen von dritten und vierten Hashtabellen, wobei jedem möglichen Kontextwert ein Eintrag in der dritten und in der vierten Hashtabelle zugeordnet ist.

12. Verfahren nach den Anspruch 11, umfassend, falls es sich bei dem ausgelesenen Wert um einen Wert des vorbestimmten Parameters einer Informationseinheit handelt:

    Ersetzen des dem Kontextwert bzgl. der aktuellen Informationseinheit zugeordneten Eintrags in der vierten Hashtabelle durch den entsprechend zugeordneten Eintrag in der dritten Hashtabelle (4.2.2 in Fig. 3); und
    Ersetzen des dem Kontextwert bzgl. der aktuellen Informationseinheit zugeordneten Eintrages in der dritten Hashtabelle durch den der aktuellen Informationseinheit zugeordneten Wert (4.2.5 in Fig. 3).

13. Verfahren nach den Anspruch 11, umfassend, falls es sich bei dem ausgelesenen Wert nicht um einen Wert des vorbestimmten Parameters handelt, und falls ein hilfsweise vorgesehener Flag gesetzt ist:

    Gegenseitiges Austauschen der dem Kontextwert bzgl. der aktuellen Informationseinheit zugeordneten Werte in der dritten und vierten Hashtabelle (4.3.1.2 in Fig. 3); und

Zuordnen des dem Kontextwert bzgl. der aktuellen Informationseinheit zugeordneten Wertes in der dritten Hashtabelle zu der aktuellen Informationseinheit (4.3.1.3 in Fig. 3).

14. Verfahren nach Anspruch 13, umfassend:

Zuordnen des dem Kontextwert bzgl. der aktuellen Informationseinheit zugeordneten Wertes in der dritten Hashtabelle zu der aktuellen Informationseinheit (4.3.2.2 in Fig. 3).

15. Verfahren nach Anspruch 11, umfassend, falls es sich bei dem ausgelesenen Wert nicht um einen Wert des vorbestimmten Parameters handelt, und falls ein hilfsweise vorgesehener Flag nicht gesetzt ist:

Zuordnen des dem Kontextwert bzgl. der aktuellen Informationseinheit zugeordneten Wertes in der dritten Hashtabelle zu der aktuellen Informationseinheit (4.3.2.2 in Fig. 3).

16. Verfahren nach Anspruch 12, umfassend ein Rücksetzen des hilfsweisen Flags (4.2.6 in Fig. 3).

17. Verfahren nach Anspruch 13, 14 oder 15, umfassend ein Setzen des hilfsweisen Flags (4.3.3 in Fig. 3).

18. Verfahren nach den Ansprüchen 11 bis 17, umfassend ein Wiederholen der Schritte für alle Werte der Eingangsdatei.

19. Verfahren nach Anspruch 18,
wobei zu Beginn der Durchführung des Verfahrens für alle Informationseinheiten die dritten und vierten Hashtabellen initialisiert werden (1 in Fig. 3), und
wobei der hilfsweise Flag zurückgesetzt wird (3 in Fig. 3).

20. Verfahren nach einem der vorhergehenden Ansprüche, wobei die Informationseinheiten durch Pixel eines Bildes gebildet werden.

21. Verfahren nach Anspruch 20, wobei der vorbestimmte Parameter durch die Pixelfarbe gebildet wird.

22. Verfahren nach den Ansprüchen 3 und 20, wobei der zweidimensionale Kontxt durch in x- und y-Richtung eines Bildes angrenzende oder naheliegende Pixel des Bildes gebildet werden.

23. Verfahren zur Kompression von Daten, die eine Vielzahl von Informationseinheiten enthalten, umfassend:

Bestimmen von einen oder mehreren Erwartungswerten für jede der Informationseinheiten;
für jede Informationseinheit Bestimmen einer Übereinstimmung des Wertes der Informationseinheit mit dem einen oder den mehreren Erwartungswerten; und
Erzeugen von Ausgangsdaten, die Informationen über Übereinstimmungen der Werte der Informationseinheiten mit dem einen oder den mehreren Erwartungswerten enthalten, sowie Informationen über die Werte der Informationseinheiten, falls Nichtübereinstimmungen mit dem einen oder den mehreren Erwartungswerten festgestellt werden, wobei die Erwartungswerte auf Grundlage von Werten von Informationseinheiten gebildet werden, die bereits den vorangegangenen Schritten zur Kompression unterzogen worden sind und in Bezug auf die vorliegende Informationseinheit einen zweidimensionalen Kontext bilden.

24. Verfahren zur Dekompression von Daten, umfassend:

Empfangen von Eingangsdaten, die den Ausgangsdaten des Verfahrens nach Anspruch 23 entsprechen;
Bestimmen der Werte von zumindest einem Teil der Vielzahl der Informationseinheiten anhand von Informationen über Übereinstimmungen der Werte mit einem oder mehreren Erwartungswerten, wobei die Erwartungswerte auf Grundlage von Werten von Informationseinheiten gebildet werden, die bereits den vorangegangenen Schritten zur Dekompression unterzogen worden sind und in Bezug auf die vorliegende Informationseinheit einen zweidimensionalen Kontext bilden.

25. Verfahren nach Anspruch 23 oder 24, wobei die Informationseinheiten durch Pixel eines zweidimensionalen Bildes gebildet werden, und der zweidimensionale Kontext durch Pixel in beiden Bilddimensionen (x, y) gebildet wird.

26. Datenverarbeitungsvorrichtung, die ausgebildet ist zur Durchführung des Verfahrens nach einem der vorhergehenden Ansprüche.

27. Programm umfassend maschinenlesbare Instruktionen zur Durchführung des Verfahrens nach einem der Ansprüche 1 bis 25 auf einer Datenverarbeitungsvorrichtung.

28. Speichermedium mit einem darauf gespeicherten maschinenlesbaren Programm nach Anspruch 27.

Fig. 1

# Fig. 2

**Fig. 3**